# EUROPEAN PATENT APPLICATION

(11) **EP 4 287 794 A1**
(43) Date of publication of application: **06.12.2023**
(21) Application number: 22773910.9
(22) Date of filing: 27.01.2022
(51) Int. Cl.: H05K 5/02, H05K 7/20

(54) **INVERTER AND INTEGRATED PLATFORM HAVING SAME**

(30) Priority: 25.03.2021 CN 202120615868 U
(71) Applicant: Sungrow Power Supply Co., Ltd., Hefei, Anhui 230088 (CN)
(72) Inventor: WANG, Xiaohu, Hefei, Anhui 230088 (CN); ZHU, Qiyao, Hefei, Anhui 230088 (CN); ZHANG, Xianwei, Hefei, Anhui 230088 (CN); TAN, Jun, Hefei, Anhui 230088 (CN)
(74) Representative: Rooney, John-Paul
(86) International application number: PCT/CN2022/074191
(87) International publication number: WO 2022/199248

(57) **Abstract**

Provided in the present invention are an inverter and an integrated platform having same. The inverter comprises a cabinet having a cabinet door, an inverter body disposed in the cabinet, and a heat exchanger disposed on the exterior of the cabinet, wherein the inverter body has an alternating-current side, and the cabinet door is located on the alternating-current side of the inverter body or on the opposite side of the alternating-current side. In the present invention, the heat exchanger is disposed on the alternating-current side of the inverter body or the opposite side of the alternating-current side, so as to guarantee that when integration design is carried out for the inverter, the whole inverter can be located in a box body, thereby reducing the difficulty and costs of integration design of the inverter.

## Description

The present application claims priority to Chinese Patent Application No. 202120615868.8, titled "INVERTER AND INTEGRATED PLATFORM HAVING SAME", filed on March 25, 2021 with the China National Intellectual Property Administration, which is incorporated herein by reference in its entirety.

### FIELD

The present application relates to the technical field of photovoltaic inverters, and in particular to an inverter and an integrated platform having the same.

### BACKGROUND

As the power of a photovoltaic inverter increases, the internal heat of the photovoltaic inverter also increases, and the protection level also increases. In order to take into account both heat dissipation and the protection level, a heat exchanger is required to be mounted to the inverter to facilitate the heat dissipation of the inverter. In the conventional technology, the position of the heat exchanger in the inverter is unreasonable, which results in a large volume of the inverter, thereby increasing the difficulty of integration design of the inverter.

### SUMMARY

The problem to be solved by the present application is how to reduce the difficulty of integration design of an inverter equipped with a heat exchanger.

To solve the above problem, an inverter is provided according to an embodiment of the present application. The inverter includes a cabinet having a cabinet door, an inverter body arranged in the cabinet, and a heat exchanger arranged on an outer side of the cabinet. The inverter body has an alternating-current side, and the cabinet door is arranged on the alternating-current side or an opposite side of the alternating-current side of the inverter body.

In an embodiment, the cabinet door includes a first door panel and a second door panel which are rotatable to be opened or closed, and the heat exchanger is arranged on the first door panel and/or the second door panel.

In an embodiment, an opening in communication with an internal space of the cabinet is provided in the first door panel and/or the second door panel, and the heat exchanger is detachably arranged at the opening.

In an embodiment, the first door panel or the second door panel is of a special-shaped panel structure which has a wide portion at an upper part and a narrow portion at a lower part, and for the first door panel or the second door panel, a vertical side of the narrow portion is flush with a vertical side of the wide portion.

In an embodiment, the cabinet door further includes a maintenance door panel, the maintenance door panel is arranged in a same plane as the first door panel and the second door panel, and the maintenance door panel is arranged between the narrow portion of the first door panel and the narrow portion of the second door pane.

In an embodiment, the cabinet is provided with a column structure arranged vertically, the column structure is arranged in the cabinet, and the wide portion of the first door panel and the wide portion of the second door panel are detachably connected to the column structure in a case that the first door panel and the second door panel are closed.

In an embodiment, a copper busbar output port is provided on the alternating-current side of the inverter body, and the copper busbar output port is configured to be connected to a copper busbar input port of a transformer through a connection structure.

In an embodiment, the copper busbar output port is arranged between the narrow portion of the first door panel and the narrow portion of the second door panel, and is arranged below the maintenance door panel.

In an embodiment, the cabinet is provided with an air duct structure, and the heat exchanger is configured to discharge absorbed heat from the air duct structure to an exterior of the cabinet.

To solve the above problem, an integrated platform is further provided according to an embodiment of the present application. The integrated platform includes a box, a transformer arranged in the box, and the inverter according to any one of the embodiments. The inverter and the transformer are respectively arranged at two ends of the box in a length direction, and the alternating-current side of the inverter faces towards the transformer.

Compared with the conventional technology, the present application has the following beneficial effects: in the present application, the heat exchanger is arranged on the alternating-current side or the opposite side of the alternating-current side of the inverter body, the entire inverter can be arranged in the box in the integration design of the inverter, reducing the difficulty and the cost of the integration design of the inverter. Moreover, the heat exchanger is arranged on the first door panel and/or the second door panel which is rotatable to be opened or closed, and the heat exchanger can be maintained only by rotating and opening the first door panel or the second door panel without disassembling the entire cabinet door. In addition, it is only required to close the first door panel or the second door panel after the maintenance is completed. The operation is simple and convenient, and the maintenance efficiency is high.

### BRIEF DESCRIPTION OF THE DRAWINGS

Figure 1 is a three-dimensional schematic structural view of an inverter according to an embodiment of the present application;
Figure 2 is a front view of an inverter according to an embodiment of the present application;
Figure 3 is a schematic structural view of an inverter according to an embodiment of the present application with a cabinet door being removed; and
Figure 4 is a schematic structural view of an integrated platform according to an embodiment of the present application.

### Reference numerals are described as follows:

1-heat exchanger, 2-cabinet, 21-cabinet door, 211-first door panel, 212-second door panel, 213-maintance door panel, 22-column structure, 23-air duct structure, 231-upper air duct, 232-lower air duct, 31-alternating-current side, 311-copper busbar output port, 100-box, 200-transformer, 300-inverter, and 400-connection structure.

### DETAILED DESCRIPTION OF THE EMBODIMENTS

In order to make the above objects, features, and advantages of the present application more apparent and understandable, the embodiments of the present application are described in detail below in conjunction with the accompanying drawings.

It should be noted that for the coordinate system XYZ provided herein, a forward direction of X-axis represents the left direction, a reverse direction of X-axis represents the right direction, a forward direction of Y-axis represents the rear direction, a reverse direction of Y-axis represents the front direction, a forward direction of Z-axis represents the upward direction, and a reverse direction of Z-axis represents the downward direction. The terms, such as "first" and "second", in the description, claims and the above drawings of the present application are used to distinguish similar objects, rather than to necessarily describe a specific order or sequence. It should be understood that the terms used in this way are interchangeable under appropriate circumstances, so that the embodiments of the present application described herein can be implemented in orders other than those illustrated or described herein.

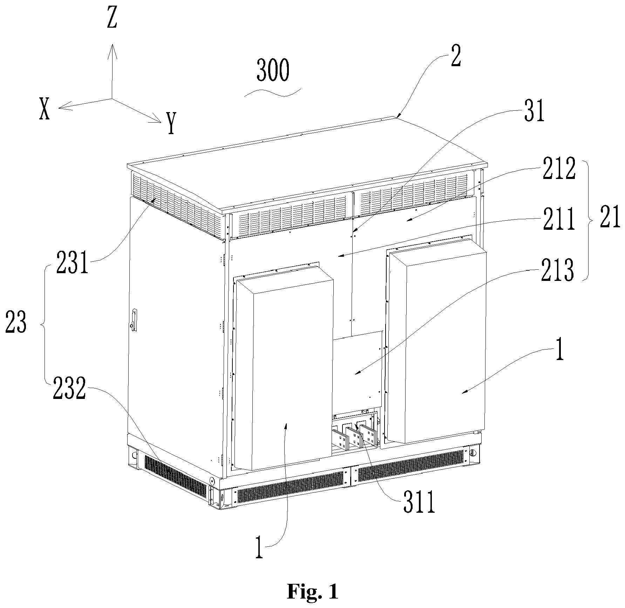

As shown in Figure 1, an inverter 300 is provided according to an embodiment of the present application. The inverter 300 includes a cabinet 2 having a cabinet door 21, an inverter body arranged in the cabinet 2, and a heat exchanger 1 arranged on an outer side of the cabinet 2. The inverter body has an alternating-current side 31, and the cabinet door 21 is arranged on the alternating-current side 31 or an opposite side of the alternating-current side 31 of the inverter body.

In the embodiment, the alternating-current side 31 of the inverter body is the rear side of the inverter 300 in Figure 1, and correspondingly, the opposite side of the alternating-current side 31 is the front side of the inverter 300 in Figure 1. As the power of the inverter 300 increases, the heat generated by the inverter 300 is also increasing, and the volume of the heat exchanger 1 is also designed to be larger, which increases the volume of the entire inverter 300. If the heat exchanger 1 is arranged on the left side or the right side of the inverter 300, the size of the width of the inverter 300 in a left-right direction (i.e. the direction of X-axis) is increased. The alternating-current side 31 of the inverter 300 is required to face towards a transformer 200 in a box 100 to facilitate the connection between the inverter 300 and the transformer 200 when the inverter 300 is integrated in the box 100 of an integrated platform, so that the inverter 300 with the heat exchanger 1 is prone to exceeding an standard internal size of the box 100 (i.e. the size of the width of the box 100 in the left-right direction) when the heat exchanger 1 is arranged on two sides (i.e. the left side or the right side) of the inverter 300 in a width direction, resulting in different integration of the inverter 300. In the embodiment, the heat exchanger 1 is arranged on the alternating-current side 31 or the opposite side of the alternating-current side 31 of the inverter body, to ensure that the entire inverter 300 can be arranged in the box 100 in the integration design of the inverter 300, reducing the difficulty and the cost of the integration design of the inverter 300.

In an embodiment, as shown in Figure 1, the cabinet door 21 includes a first door panel 211 and a second door panel 212 which are rotatable to be opened or closed, and the heat exchanger 1 is arranged on the first door panel 211 and/or the second door panel 212.

Due to the fact that the heat exchanger in the conventional technology is usually arranged on the cabinet door inside the cabinet of the inverter and on the outer side of the cabinet door, and the cabinet door is a single door panel structure, the entire cabinet door is required to be removed when the heat exchanger is required to be maintained, and the cabinet door and the heat exchanger are installed on the cabinet of the inverter after the maintenance is completed. The whole operation process is relatively cumbersome and inefficient. In the embodiment, in order to slightly change the original structure of the inverter 300, the heat exchanger 1 is usually installed on the outer side the cabinet 2 of the inverter 300 when installing the heat exchanger 1 to the inverter 300. In this way, adaptive improvements are required to be made to only the cabinet 2 of the inverter 300 to install the heat exchanger 1 without changing the structure of the inverter body, thereby reducing the research and development cost and the difficulty of redeveloping a new inverter 300. Meanwhile, the heat exchanger 1 being arranged on the outer side of the cabinet 2 can reduce the size and the cost of the cabinet 2. Moreover, in the cabinet 2 of the inverter 300, the cabinet door 21 on the side where the heat exchanger 1 is located is not a single door panel structure, and is composed of two door panels, that is, the cabinet door 21 includes a first door panel 211 and a second door panel 212. In a case that the power of the inverter 300 is low, the heat exchanger 1 may be installed on the first door panel 211 or the second door panel 212 to meet heat dissipation requirements of the inverter 300 with low power. In a case that the power of the inverter 300 is high, the heat dissipation effect may be improved by increasing of the volume of the heat exchanger 1 on the first door panel 211 or the second door panel 212, or the heat dissipation effect may be improved by installing of heat exchangers 1 on the first door panel 211 and the second door panel 212 respectively. From the perspective of the overall volume of the inverter 300, in the embodiment, it is preferable to install the heat exchangers 1 on the first door panel 211 and the second door panel 212 respectively to improve the heat dissipation effect of the heat exchanger 1 in the case that the power of the inverter 300 is high, so as to avoid increasing the overall size and the volume of the inverter 300. Moreover, the first door panel 211 and the second door panel 212 are rotatable to be opened or closed, so that the heat exchanger 1 can be maintained only by rotating and opening the first door panel 211 or the second door panel 212 without disassembling the entire cabinet door 21, and it is only required to close the first door panel 211 or the second door panel 212 after the maintenance is completed. The operation is simple and convenient, and the maintenance efficiency is high.

In an embodiment, the cabinet 2 further includes a frame, and the frame is composed of multiple longitudinal beams and multiple cross beams. The first door panel 211 and the second door panel 212 are configured to be fixed to the cross beams or the longitudinal beams of the frame by fasteners in a case of being closed.

The inverter 300 is usually subjected to various vibration shocks during transportation or carrying. In a case that the first door panel 211 and second door panel 212 are closed only under the action of friction, the first door panel 211 and/or the second door panel 212 are easy to be opened when subjected to the vibration shocks, and the inverter body in the cabinet 2 is exposed to the transportation environment, so that the inverter body is easily damaged by impacts of other objects. In the embodiment, the first door panel 211 and the second door panel 212 are required to be fixed to the frame of the cabinet 2 by fasteners such as screws after the first door panel 211 and the second door panel 212 are closed, so as to prevent the inverter 300 from being damaged during transportation or carrying, thereby ensuring the reliability and the safety of the inverter 300 during transportation or carrying.

Further, the first door panel 211 and the second door panel 212 are arranged symmetrically on the left and the right. In this way, the aesthetics of the cabinet door 21 is improved, the structure of the cabinet door 21 is simplified, the types of the manufactured door panels are reduced, and the production efficiency is improved. That is, producing a door panel structure of a same specification is sufficient for cabinets 2 of a same model. During the assembly, it is not required to distinguish the door panel arranged on the left and the door panel arranged on the right, and it is only required to rotate the other of the two door panels of the same specification by 180 degrees and install the other, thereby improving the assembly efficiency of the cabinet door 21.

In an embodiment, an opening in communication with an internal space of the cabinet 2 is provided in the first door panel 211 and/or the second door panel 212, and the heat exchanger 1 is detachably arranged at the opening.

In the embodiment, the heat exchanger 1 is detachably arranged on the first door panel 211 and/or the second door panel 212. For example, a first mounting hole is arranged around the opening in the first door panel 211 and/or the second door panel 212, and a second mounting hole is arranged in the heat exchanger 1. The first mounting hole is aligned with the second mounting hole, and the fastener such as a screw is screwed into the first mounting hole and the second mounting hole, so that the heat exchanger 1 is fixed on the first door panel 211 and/or the second door panel 212 to be detachably connected. Moreover, the opening is provided, so that the heat exchanger 1 is communicated with the internal space of the cabinet 2, and the contact area between the heat exchanger 1 and hot air inside the cabinet 2 is increased, facilitating the heat exchanger 1 to absorb the heat inside the cabinet 2 and discharge the heat to the exterior of the cabinet 2.

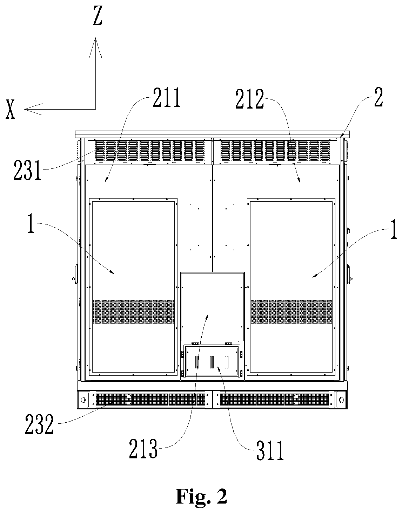

In an embodiment, as shown in Figure 2, the first door panel 211 and/or the second door panel 212 is of a special-shaped panel structure which has a wide portion at an upper part and a narrow portion at a lower part, and for the first door panel 211 or the second door panel 212, a vertical side of the narrow portion is flush with a vertical side of the wide portion.

In the embodiment, the first door panel 211 and/or the second door panel 212 is of an inverted L-shaped panel structure with a wide portion at an upper part and a narrow portion at a lower part. The vertical side of the wide portion is the left side or the right side of the wide portion, and correspondingly, the vertical side of the narrow portion is the left side or the right side of the narrow portion. Specifically, taking the structure of the first door panel 211 as an example for illustration, the wide portion of the first door panel 211 is arranged above the narrow portion of the first door panel 211, and the narrow portion of the first door panel 211 is arranged on the left-lower side of the wide portion of the first door panel 211, so that the inverted L-shaped panel structure of the first door panel 211 is formed. The size of the wide portion of the first door panel 211 in the left-right direction is larger than the size of the narrow portion of the first door panel 211 in the left-right direction. The left side of the wide portion of the first door panel 211 is aligned with the left side of the narrow portion of the first door panel 211, or the right side of the wide portion of the first door panel 211 is aligned with the right side of the narrow portion of the first door panel 211. In this way, the first door panel 211 and/or the second door panel 212 of the inverter 300 is designed as the special-shaped panel structure with the wide portion and the narrow portion, so that a larger installation space or maintenance space can be exposed in a case that the first door panel 211 and the second door panel 212 are opened, facilitating installation and maintenance of structural components such as a capacitor bank in the inverter body. Moreover, it is not required to arrange another cabinet door structure on the upper part at the alternating-current side 31, so as to avoid blocking the installation space of the inverter body or increasing the production cost of the cabinet 2.

In an embodiment, as shown in Figure 1, the cabinet door 21 further includes a maintenance door panel 213, the maintenance door panel 213 is arranged in a same plane as the first door panel 211 and the second door panel 212, and the maintenance door panel 213 is arranged between the narrow portion of the first door panel 211 and the narrow portion of the second door panel 212.

In the embodiment, an area enclosed by the wide portion and the narrow portion of the first door panel 211 and an area enclosed by the wide portion and the narrow portion of the second door panel 212 are oppositely arranged. That is, the first door panel 211 and the second door panel 212 jointly enclose a rectangular area with an open bottom, the maintenance door panel 213 is arranged in the area enclosed by the first door panel 211 and the second door panel 212, and the maintenance door panel 213 is arranged in the same plane as the first door panel 211 and the second door panel 212, so as to prevent a gap generated when the maintenance door panel 213 is misaligned with the first door panel 211 and the second door panel 212, thereby preventing potential water leakage. In this way, the maintenance door panel 213 is provided, and thus the repair and maintenance operation can be performed only by disassembling the maintenance door panel 213 when it is required to repair and maintain a part of the inverter body without opening the first door panel 211 and the second door panel 212. Therefore, it is enabled to selectively open the first door panel 211 and/or the second door panel 212, or disassemble the maintenance door panel 213, according to the actual needs in operation, for the repair and maintenance operation, so as to improve the operation efficiency.

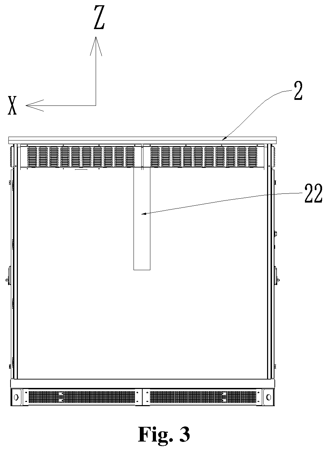

In an embodiment, as shown in Figure 3, the cabinet 2 is provided with a column structure 22 arranged vertically, and the column structure 22 is arranged in the cabinet 2. The wide portion of the first door panel 211 and the wide portion of the second door panel 212 are detachably connected to the column structure 22 in a case that the first door panel 211 and the second door panel 212 are closed.

In an embodiment, the column structure 22 is vertically arranged on the central position of the upper part of the cabinet door 21, and the wide portion of the first door panel 211 and the wide portion of the second door panel 212 are detachably fixed at the left end and the right end of the column structure 22 respectively, for example, detachably fixed through fasteners, such as screws, or a snap-fit structure. Due to the existence of production errors, a certain gap exists between the wide portion of the first door panel 211 and the wide portion of the second door panel 212 after the first door panel 211 and the second door panel 212 are closed, and thus liquids such as rainwater enter the cabinet 2 through the gap, which easily leads to short circuit or damage of the inverter 300 and affects the operation of the inverter 300. In an embodiment, the column structure 22 is provided, the wide portions of the first door panel 211 and the second door panel 212 are detachably connected to the column structure 22, so that the column structure 22 can block a gap between the wide portion of the first door panel 211 and the wide portion of the second door panel 212 after the first door panel 211 and the second door panel 212 are closed, preventing liquids such as rainwater from entering the cabinet 2 through the gap, ensuring the normal operation of the inverter 300, and also prolonging the service life of the inverter 300.

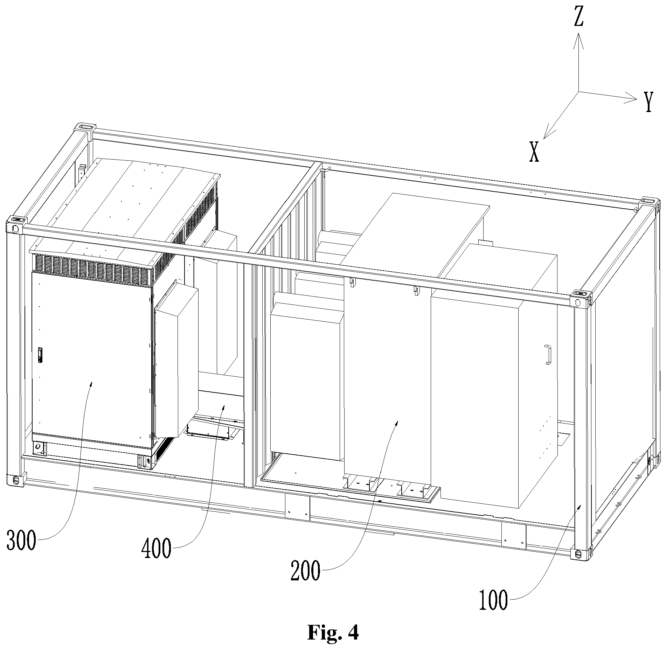

In an embodiment, as shown in Figures 1 and 4, a copper busbar output port 311 is provided on the alternating-current side 31 of the inverter body, the copper busbar output port 311 is configured to be connected to a copper busbar input port of a transformer 200 through a connection structure 400.

The alternating-current side 31 of the inverter 300 is usually oriented towards the transformer 200 in the integrated platform during the integration design of the inverter 300. In the embodiment, the copper busbar output port 311 is arranged on the alternating-current side 31 of the inverter 300 to facilitate the inverter 300 to be directly connected to the transformer 200 through the connection structure 400, which facilitates the connection, shortens the length of the connection structure 400 that is required, and saves the cost of the connection structure 400.

In an embodiment, alternatively, the copper busbar output port 311 may be arranged below the inverter body, and the copper busbar output port 311 first extends towards the underside of the cabinet 2 and then towards the rear side of the cabinet 2, so that the output end of the copper busbar output port 311 is arranged on the alternating-current side 31 of the inverter 300, facilitating the inverter 300 to be directly connected to the transformer 200 through the connection structure 400.

Furthermore, the connection structure 400 is a copper busbar, that is, the copper busbar output port 311 of the inverter 300 is electrically connected to the copper busbar input port of the transformer 200 through the copper busbar, facilitating the inverter 300 to output alternating current to the transformer 200 through the copper busbar.

In an embodiment, as shown in Figure 1 and Figure 2, the copper busbar output port 311 is arranged between the narrow portion of the first door panel 211 and the narrow portion of the second door panel 212, and is arranged below the maintenance door panel 213. In this way, the copper busbar output port 311 is arranged at the bottom of the cabinet 2 and below the maintenance door panel 213, so as to prevent the connection structure 400 from blocking the installation space and the maintenance space of the inverter body after the inverter 300 is connected to the transformer 200 through the connection structure 400, thereby further ensuring the maintainability of the inverter body.

In an embodiment, as shown in Figure 1, the cabinet 2 is provided with an air duct structure 23, and the heat exchanger 1 is configured to discharge absorbed heat from the air duct structure 23 to an exterior of the cabinet 2. In this way, the provision of the air duct structure 23 not only facilitates the heat exchanger 1 to discharge the absorbed heat generated by the inverter 300 when operating from the air duct structure 23 to the exterior of the cabinet 2, but also facilitates the heat generated in the cabinet 2 to diffuse from the air duct structure 23 to the exterior of the cabinet 2 under the flow of air inside and outside the cabinet 2, playing a certain role of ventilation and heat dissipation.

Furthermore, the air duct structure 23 includes an upper air duct 231 and a lower air duct 232. The upper air duct 231 is arranged at the upper end of the cabinet 2, and the lower air duct 232 is arranged at the lower end of the cabinet 2. The upper air duct 231 and the lower air duct 232 each is of a louver structure. In this way, the air ducts in the louver structures are respectively arranged at the upper and lower ends of the cabinet 2 to increase the heat-dissipation area of the cabinet 2, thereby further improve the heat-dissipation effect of the inverter 300.

In order to solve the above problems, an integrated platform is provided according to another embodiment of the present application. The integrated platform includes a box 100, a transformer 200 arranged in the box 100, and the inverter 300 according to any one of the above embodiments. The inverter 300 and the transformer 200 are respectively arranged at two ends of the box 100 in a length direction, and the alternating-current side 31 of the inverter 300 faces towards the transformer 200. The length direction of the box 100 refers to the direction of X-axis in Figure 4, i.e., a front-back direction of the box 100. Correspondingly, a width direction of the box 100 refers to the direction of Y-axis in Figure 4, i.e., a left-right direction of the box 100.

In the integrated platform according to the embodiment, the inverter 300 is integrated inside the box 100 and at an end of the box 100 in the length direction, and the heat exchanger 1 is arranged on the alternating-current side 31 of the inverter 300, in order not to increase the size of the inverter 300 in the width direction (i.e. the direction of Y-axis in Figure 4), so that the width of the entire inverter 300 does not exceed the width of the box 100, facilitating transportation and transfer. Moreover, the heat exchanger 1 is arranged on the alternating-current side 31 of the inverter 300, so that the increase of the volume of the heat exchanger 1 does not affect the integration design of the inverter 300 in the integrated platform. In addition, the heat exchanger 1 is arranged on the first door panel 211 and/or the second door panel 212, which is rotatable to be opened or closed, of the inverter 300, so that the heat exchanger 1 can be maintained only by rotating and opening the first door panel 211 or the second door panel 212 without disassembling the entire cabinet door 21. In addition, it is only required to close the first door panel 211 or the second door panel 212 after the maintenance is completed. The operation is simple and convenient, and the maintenance efficiency is high.

Although the present application is disclosed as above, the scope of protection of the present application is not limited thereto. Various changes and modifications can be made by those skilled in the art without departing from the spirit and the scope of the present application, and the changes and modifications shall fall within the scope of protection of the present application.

## Claims

1. An inverter, comprising:
a cabinet (2) having a cabinet door (21);
an inverter body arranged in the cabinet (2); and
a heat exchanger (1) arranged on an outer side of the cabinet (2), wherein
the inverter body has an alternating-current side (31), and the cabinet door (21) is arranged on the alternating-current side (31) or an opposite side of the alternating-current side (31) of the inverter body.

2. The inverter according to claim 1, wherein the cabinet door (21) comprises a first door panel (211) and a second door panel (212) which are rotatable to be opened or closed, and the heat exchanger (1) is arranged on the first door panel (211) and/or the second door panel (212).

3. The inverter according to claim 2, wherein an opening in communication with an internal space of the cabinet (2) is provided in the first door panel (211) and/or the second door panel (212), and the heat exchanger (1) is detachably arranged at the opening.

4. The inverter according to claim 2, wherein the first door panel (211) and/or the second door panel (212) is of a special-shaped panel structure which has a wide portion at a upper part and a narrow portion at a lower part, and for the first door panel (211) or the second door panel (212), a vertical side of the narrow portion is flush with a vertical side of the wide portion.

5. The inverter according to claim 4, wherein the cabinet door (21) further comprises a maintenance door panel (213), the maintenance door panel (213) is arranged in a same plane as the first door panel (211) and the second door panel (212), and the maintenance door panel (213) is arranged between the narrow portion of the first door panel (211) and the narrow portion of the second door panel (212).

6. The inverter according to claim 4, wherein the cabinet (2) is provided with a column structure (22) arranged vertically, the column structure (22) is arranged in the cabinet (2), and the wide portion of the first door panel (211) and the wide portion of the second door panel (212) are detachably connected to the column structure (22) in a case that the first door panel (211) and the second door panel (212) are closed.

7. The inverter according to claim 5, wherein a copper busbar output port (311) is provided on the alternating-current side (31) of the inverter body, and the copper busbar output port (311) is configured to be connected to a copper busbar input port of a transformer (200) through a connection structure (400).

8. The inverter according to claim 7, wherein the copper busbar output port (311) is arranged between the narrow portion of the first door panel (211) and the narrow portion of the second door panel (212), and is arranged below the maintenance door panel (213).

9. The inverter according to claim 1, wherein the cabinet (2) is provided with an air duct structure (23), and the heat exchanger (1) is configured to discharge absorbed heat from the air duct structure (23) to an exterior of the cabinet (2).

10. An integrated platform, comprising:
a box (100);
a transformer (200) arranged in the box (100); and
the inverter according to any one of claims 1 to 9, wherein
the inverter and the transformer (200) are respectively arranged at two ends of the box (100) in a length direction, and the alternating-current side (31) of the inverter faces towards the transformer.
